(19) Europäisches Patentamt
European Patent Office
Office européen des brevets

(11) **EP 3 814 782 B1**

(12) **FASCICULE DE BREVET EUROPEEN**

(45) Date de publication et mention
de la délivrance du brevet:
**16.08.2023 Bulletin 2023/33**

(21) Numéro de dépôt: **19731750.6**

(22) Date de dépôt: **24.06.2019**

(51) Classification Internationale des Brevets (IPC):
**G01R 15/18** (2006.01)  **G01R 33/04** (2006.01)
**G01R 23/20** (2006.01)  **H01F 27/28** (2006.01)

(52) Classification Coopérative des Brevets (CPC):
**G01R 15/185; G01R 23/20; G01R 33/04;**
H01F 2027/2809

(86) Numéro de dépôt international:
**PCT/EP2019/066583**

(87) Numéro de publication internationale:
**WO 2020/002184 (02.01.2020 Gazette 2020/01)**

(54) **CAPTEUR DE COURANT A VANNE DE FLUX**

STROMSENSOR MIT FLUX-GATE

CURRENT SENSOR WITH FLUX GATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.06.2018 FR 1855755**

(43) Date de publication de la demande:
**05.05.2021 Bulletin 2021/18**

(73) Titulaire: **Safran Electronics & Defense**
**75015 Paris (FR)**

(72) Inventeurs:
• **CHETANNEAU, Patrice**
**77550 Moissy-Cramayel (FR)**
• **GUILLOT, François**
**77550 Moissy-Cramayel (FR)**

(74) Mandataire: **Lavaud, Thomas**
**Cabinet Boettcher**
**5, rue de Vienne**
**75008 Paris (FR)**

(56) Documents cités:
**WO-A2-2014/047644     FR-A1- 3 060 757**
**US-A1- 2017 219 632**

**Description**

L'invention concerne le domaine des capteurs de courant à vanne de flux.

ARRIERE PLAN DE L'INVENTION

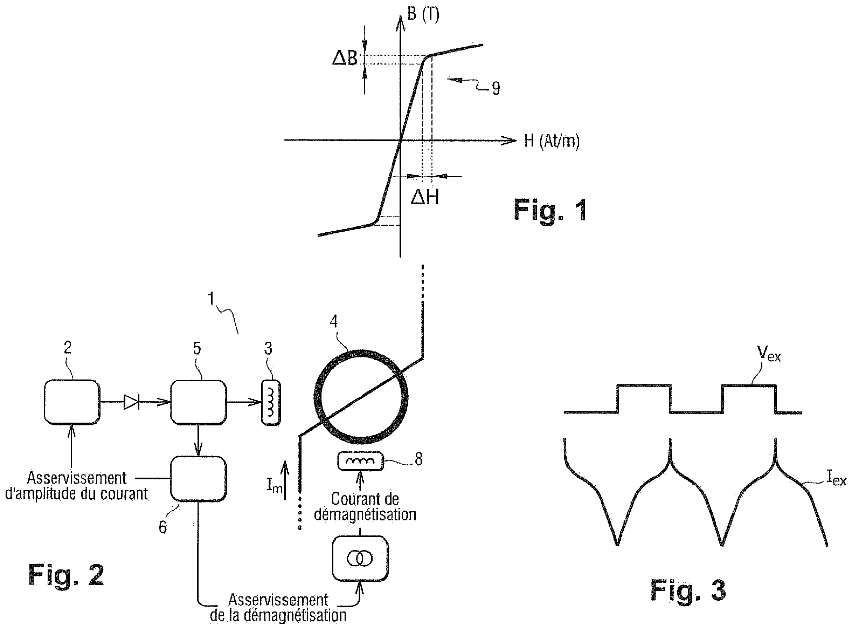

Un capteur de courant à vanne de flux utilise la propriété d'un matériau magnétique formant un noyau magnétique de se saturer à partir d'un certain niveau d'excitation magnétique. En référence à la figure 1, pour un champ magnétique H croissant, la pente de la fonction de transfert entre le champ magnétique H et l'induction magnétique B diminue grandement à partir d'une valeur dite de saturation du noyau magnétique. La valeur de saturation, sur la figure 1, correspond aux intervalles $\Delta H$ et $\Delta B$.

En référence aux figures 2 et 3, dans un capteur de courant à vanne de flux classique 1 destiné à mesurer un courant Im circulant sur un conducteur, un générateur de signaux rectangulaires 2 applique une tension d'excitation rectangulaire Vex aux bornes d'un enroulement d'excitation 3 enroulé autour d'un noyau magnétique 4. Le courant d'excitation Iex circulant dans l'enroulement d'excitation 3 est mesuré par un module de mesure 5. Un détecteur de crêtes 6, relié au module de mesure 5, fournit deux informations : le niveau de saturation et la différence des courants de crête du courant d'excitation Iex. Le niveau de saturation permet d'asservir l'amplitude de la tension d'excitation Vex. La différence des courants de crête du courant d'excitation Iex permet d'estimer le courant à mesurer Im et d'asservir, via un convertisseur de tension en courant 7, l'amplitude d'un courant de démagnétisation qui circule dans un enroulement de démagnétisation 8 et qui permet de compenser le flux magnétique produit dans le noyau magnétique 4 par le courant à mesurer Im.

Les capteurs de courant à vanne de flux sont privilégiés dans un certain nombre d'applications. C'est notamment le cas pour la mesure d'un courant circulant dans un organe de coupure de type SSPC (pour « Solid State Power Controller ») à destination d'un équipement utilisateur, ou bien pour la mesure d'un courant circulant dans un organe de conversion d'énergie de type PEM (pour « Power Electronic Module ») relié à une phase d'un moteur.

OBJET DE L'INVENTION

L'invention a pour objet d'améliorer la reproductibilité industrielle et de réduire le coût d'un capteur de courant à vanne de flux.

RESUME DE L'INVENTION

En vue de la réalisation de ce but, on propose un capteur de courant à vanne de flux comportant un noyau magnétique qui s'étend autour d'un conducteur sur lequel circule un courant à mesurer, un enroulement de mesure, un circuit d'excitation agencé pour générer un signal d'excitation numérique, un circuit d'acquisition comprenant un convertisseur analogique numérique et agencé pour acquérir une tension de mesure analogique aux bornes de l'enroulement de mesure et pour produire un signal de mesure numérique, un circuit d'asservissement de démagnétisation agencé pour produire, à partir du signal de mesure numérique, un signal de démagnétisation numérique destiné à compenser un flux magnétique produit par le courant à mesurer, un sommateur agencé pour sommer le signal d'excitation numérique et le signal de démagnétisation numérique de manière à obtenir un signal d'injection numérique, et un circuit d'injection comprenant un convertisseur numérique analogique et agencé pour produire un courant d'excitation analogique à partir du signal d'injection numérique et pour injecter le courant d'excitation analogique dans l'enroulement de mesure.

Le capteur de courant à vanne de flux selon l'invention comporte donc un unique enroulement de mesure qui permet à la fois d'exciter le noyau magnétique, de démagnétiser le noyau magnétique et d'acquérir la tension de mesure analogique pour estimer le courant à mesurer. On simplifie et on réduit ainsi l'encombrement, la masse et le coût de fabrication du capteur de courant à vanne de flux selon l'invention.

De plus, une grande partie de la chaîne de traitement du capteur de courant à vanne de flux selon l'invention est numérique. L'utilisation d'une chaîne de traitement principalement numérique permet de réduire encore le coût de fabrication du capteur de courant à vanne de flux selon l'invention et d'améliorer sa reproductibilité industrielle.

L'invention sera mieux comprise à la lumière de la description qui suit d'un mode de mise en oeuvre particulier non limitatif de l'invention.

BREVE DESCRIPTION DES DESSINS

Il sera fait référence aux dessins annexés, parmi lesquels :

- la figure 1 représente la courbe d'une fonction de transfert entre un champ magnétique et une induction magnétique ;

- la figure 2 représente un capteur de courant à vanne de flux selon l'art antérieur ;
- la figure 3 représente la courbe d'une tension d'excitation et la courbe d'un courant d'excitation qui excitent un noyau magnétique d'un capteur de courant à vanne de flux selon l'art antérieur ;
- la figure 4 représente un capteur de courant à vanne de flux selon l'invention ;
- la figure 5 représente un pont diviseur de courant utilisé pour mesurer le courant à mesurer ;
- la figure 6 est une vue en coupe d'un circuit imprimé et d'un transformateur utilisés dans le capteur de courant à vanne de flux selon l'invention ;
- la figure 7 est une vue analogue à celle de la figure 6, mais de dessus.

DESCRIPTION DETAILLEE DE L'INVENTION

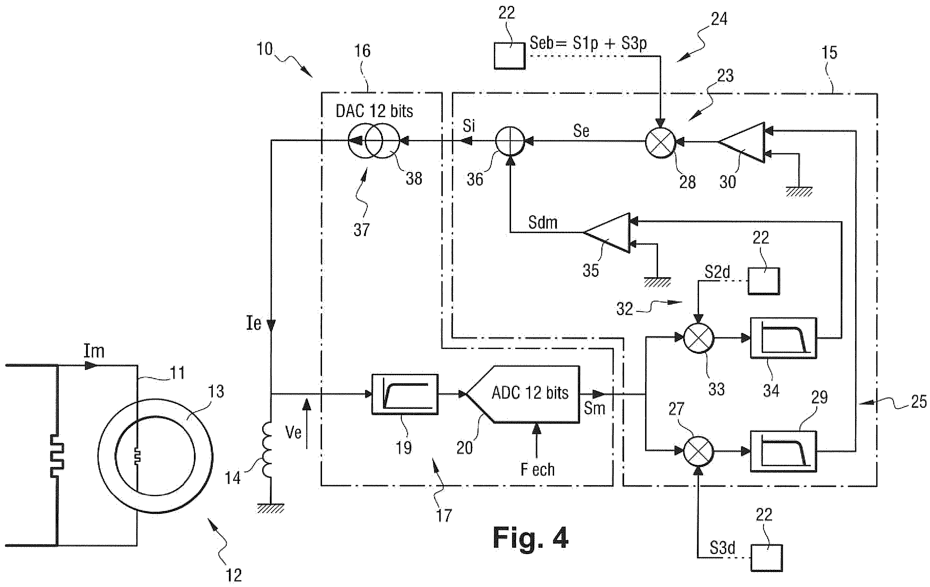

En référence à la figure 4, un capteur de courant à vanne de flux 10 selon l'invention est ici utilisé pour mesurer un courant à mesurer Im qui circule sur un conducteur 11.

Le capteur de courant à vanne de flux 10 comporte un transformateur 12 comprenant un noyau magnétique 13, un enroulement primaire et un enroulement secondaire. L'enroulement primaire est le conducteur 11. Le noyau magnétique 13 s'étend autour du conducteur 11. L'enroulement secondaire est un enroulement de mesure 14 enroulé autour du noyau magnétique 13.

Le capteur de courant à vanne de flux 10 comporte une pluralité de composants électroniques formant une partie numérique 15 et une partie analogique 16.

La partie numérique 15 comporte un composant de traitement numérique qui est en l'occurrence un FPGA mais qui pourrait être un composant différent : microcontrôleur, processeur, ASIC, etc.

Le capteur de courant à vanne de flux 10 comprend de plus un circuit d'acquisition 17. Le circuit d'acquisition 17 appartient à la partie analogique 16.

Le circuit d'acquisition 17 est relié à l'enroulement de mesure 14.

Le circuit d'acquisition 17 comprend un filtre passe-haut 19 et un convertisseur analogique numérique 20 connecté à une sortie du filtre passe-haut 19.

Le convertisseur analogique numérique 20 est ici un convertisseur 12 bits dont le fonctionnement est cadencé à une fréquence Fech. Ici Fech = 100MHz. Le convertisseur analogique numérique 20 pourrait bien sûr présenter des caractéristiques différentes.

Le circuit d'acquisition 17 acquiert une tension de mesure analogique Ve aux bornes de l'enroulement de mesure 14. La tension de mesure Ve est appliquée en entrée du filtre passe-haut 19.

La tension résultante est appliquée en entrée du convertisseur analogique numérique 20 qui produit un signal de mesure numérique Sm.

Le capteur de courant à vanne de flux 10 comprend un générateur haute fréquence 22. Le générateur haute fréquence 22 est intégré dans le FPGA (on pourrait remplacer le terme « intégré » par l'un des termes suivants : programmé, implémenté, mis en oeuvre, etc.)

Le générateur haute fréquence 22 produit un signal de référence numérique de fréquence f0, un signal de référence numérique de fréquence 2.f0 et un signal de référence numérique de fréquence 3.f0.

Le signal de référence numérique de fréquence f0 est ici de la forme :

$$\mathtt{S1r\ =\ sin(\omega0t).}$$

Le signal de référence numérique de fréquence 2.f0 est ici de la forme :

$$\mathtt{S2r\ =\ cos(2.\omega0t).}$$

Le signal de référence numérique de fréquence 3.f0 est ici de la forme :

$$\mathtt{S3r\ =\ sin(3.\omega0t).}$$

Le capteur de courant à vanne de flux 10 comprend de plus un circuit d'excitation 23. Le circuit d'excitation 23 est implémenté dans le FPGA.

Le circuit d'excitation 23 est relié au générateur haute fréquence 22.

Le circuit d'excitation 23 comporte un circuit d'excitation brute 24 et un circuit d'asservissement d'excitation 25.

Le circuit d'excitation brute 24 reçoit le signal de référence numérique de fréquence f0 et le signal de référence numérique de fréquence 3.f0 et produit à partir de ces signaux un signal d'excitation partiel numérique de fréquence f0 et un signal d'excitation partiel numérique de fréquence 3.f0.

Le signal d'excitation partiel numérique de fréquence f0 est ici de la forme :

$$\texttt{S1p = k1.sin($\omega$0t).}$$

Le signal d'excitation partiel numérique de fréquence 3.f0 est ici de la forme :

$$\texttt{S3p = k2.sin(3.$\omega$0t).}$$

Le circuit d'excitation brute 24 additionne le signal d'excitation partiel numérique de fréquence f0 et le signal d'excitation partiel numérique de fréquence 3.f0 pour générer un signal d'excitation numérique brut. Le signal d'excitation numérique brut est de la forme :

$$\texttt{Seb = S1p + S3p = k1.sin($\omega$0t) + k2.sin(3$\omega$0t).}$$

Le circuit d'asservissement d'excitation 25 est relié au générateur haute fréquence 22.
Le circuit d'asservissement d'excitation 25 reçoit le signal de référence numérique de fréquence 3.f0 et produit à partir du signal de référence numérique de fréquence 3.f0 un signal de démodulation numérique de fréquence 3.f0.
Le signal de démodulation numérique de fréquence 3.f0 est ici de la forme :

$$\texttt{S3d = k3.sin(3.$\omega$0t).}$$

Le circuit d'asservissement d'excitation 25 comporte un premier multiplieur 27, un deuxième multiplieur 28, un intégrateur 29 et un premier amplificateur 30. Le premier amplificateur 30 est connecté à une sortie de l'intégrateur 29.
Le premier multiplieur 27 multiplie le signal de mesure numérique Sm par le signal de démodulation numérique de fréquence 3.f0. Le signal résultant est appliqué en entrée de l'intégrateur 29.
On note que le premier multiplieur 27 et l'intégrateur 29 jouent le rôle d'un premier démodulateur synchrone.
Le premier amplificateur 30 produit alors un signal d'erreur numérique. Le deuxième multiplieur 28 multiplie le signal d'excitation numérique brut Seb par le signal d'erreur numérique pour obtenir un signal d'excitation numérique. Le signal d'excitation numérique est de la forme :

$$\texttt{Se = k0.(k1.sin($\omega$0t) + k2.sin(3$\omega$0t)).}$$

Le capteur de courant à vanne de flux 10 comprend de plus un circuit d'asservissement de démagnétisation 32. Le circuit d'asservissement de démagnétisation 32 est intégré dans le FPGA.
Le circuit d'asservissement de démagnétisation 32 est relié au générateur haute fréquence 22.
Le circuit d'asservissement de démagnétisation 32 reçoit le signal de référence numérique de fréquence 2.f0 et produit à partir du signal de référence numérique de fréquence 2.f0 un signal de démodulation numérique de fréquence 2.f0.
Le signal de démodulation numérique de fréquence 2.f0 est ici de la forme :

$$\texttt{S2d = k4.cos(2.$\omega$0t).}$$

Le circuit d'asservissement de démagnétisation 32 comporte un troisième multiplieur 33, un filtre passe-bas 34 et un deuxième amplificateur 35. Le deuxième amplificateur 35 est connecté à une sortie du filtre passe-bas 34.
Le troisième multiplieur 33 multiplie le signal de mesure numérique Sm par le signal de démodulation numérique de fréquence 2.f0. Le signal résultant est appliqué en entrée du filtre passe-bas 34. Le deuxième amplificateur 35 produit alors un signal image numérique du courant à mesurer Im, qui est aussi un signal de démagnétisation numérique Sdm. Le signal image numérique, ou signal de démagnétisation numérique Sdm, est de la forme Sdm = k.Im.
On note que le troisième multiplieur 33 et le filtre passe-bas 34 jouent le rôle d'un deuxième démodulateur synchrone.

Le capteur de courant à vanne de flux 10 comprend de plus un sommateur 36. Le sommateur 36 est implémenté dans le FPGA.

Le sommateur 36 somme le signal d'excitation numérique Se et le signal de démagnétisation numérique Sdm pour obtenir un signal d'injection numérique Si.

On a :

$$\text{Si = k0.(k1.sin(}\omega\text{0t) + k2.sin(3}\omega\text{0t)) + kIm.}$$

Le capteur de courant à vanne de flux 10 comporte en outre un circuit d'injection 37. Le circuit d'injection 37 appartient à la partie analogique 16.

Le circuit d'injection 37 est relié au sommateur 36 et à l'enroulement de mesure 14.

Le circuit d'injection 37 comprend un convertisseur numérique analogique 38.

Le convertisseur numérique analogique 38 est ici un convertisseur 12 bits dont le fonctionnement est cadencé à la fréquence Fech (Fech = 100MHz). Le convertisseur numérique analogique 38 pourrait bien sûr présenter des caractéristiques différentes.

Le convertisseur numérique analogique 38 acquiert le signal d'injection numérique Si, produit un courant d'excitation analogique Ie à partir du signal d'injection numérique Si, et injecte le courant d'excitation Ie dans l'enroulement de mesure 14.

On décrit maintenant le fonctionnement du capteur de courant à vanne de flux 10.

Le circuit d'excitation 23 génère un signal d'excitation numérique Se, qui est transformé en un courant d'excitation Ie et injecté dans l'enroulement de mesure 14.

La tension de mesure Ve est acquise puis numérisée pour produire un signal de mesure numérique Sm.

En sortie du deuxième amplificateur 35, on obtient un signal image numérique du courant à mesurer Im. Ce signal image numérique est utilisé pour estimer le courant à mesurer Im.

Le signal image numérique est aussi un signal de démagnétisation numérique Sdm qui permet de compenser le flux magnétique produit par le courant à mesurer Im.

Grâce au sommateur 36 et par mise en parallèle, on additionne facilement le signal de démagnétisation numérique Sdm et le signal d'excitation numérique Se. Le courant d'excitation Ie permet donc à la fois d'exciter le noyau magnétique 13 et de démagnétiser le noyau magnétique 13. Le courant de démagnétisation est donc intégré dans le courant d'excitation Ie.

La saturation du noyau magnétique 13 provoque une dissymétrie de la tension de mesure Ve, ladite tension de mesure Ve étant constituée par la somme d'une composante de fréquence f0 en sin($\omega$0t), correspondant à la fondamentale, et d'une composante de fréquence 2.f0 en cos(2$\omega$0t), correspondant à la composante harmonique d'ordre 2.

On note que l'amplitude du signal d'excitation partiel numérique de fréquence f0 et celle du signal d'excitation partiel numérique de fréquence 3.f0 sont réglées pour obtenir un courant d'excitation Ie dont la composante de fréquence 3.f0 (ou composante harmonique d'ordre 3) est en phase avec la composante de fréquence f0 (ou fondamentale).

La composante harmonique d'ordre 3 de la tension de mesure Ve, obtenue après démodulation synchrone via le premier démodulateur synchrone, est positive. En cas de saturation du noyau magnétique 13, la composante harmonique d'ordre 3 est atténuée plus fortement que la fondamentale et la composante harmonique d'ordre 3 après démodulation synchrone devient négative, car l'harmonique d'ordre 3 passe en opposition de phase avec la fondamentale.

Ainsi, lorsque le courant d'excitation Ie est tel que le noyau magnétique 13 se rapproche de la saturation, le rapport de l'amplitude de la composante harmonique d'ordre 1 et de l'amplitude de la composante harmonique d'ordre 3 de la tension de mesure Ve évolue jusqu'à annulation de la composante harmonique d'ordre 3, puis jusqu'à inversion de phase de la composante harmonique d'ordre 3. Le point de fonctionnement correspondant à l'annulation de la composante harmonique d'ordre 3 de la tension de mesure Ve est donc un point de fonctionnement optimal du capteur de courant à vanne de flux 10. Ce point de fonctionnement optimal correspond au coude 9 de la courbe de fonction de transfert de la figure 1.

En sortie du premier amplificateur 30, on obtient un signal d'erreur numérique.

Le signal d'erreur numérique permet d'asservir le courant d'excitation Ie. L'asservissement consiste à contrôler le courant d'excitation Ie pour annuler la composante harmonique d'ordre 3 de la tension de mesure Ve. Le capteur de courant à vanne de flux 10 fonctionne ainsi en permanence sur le point de fonctionnement optimal. On obtient de la sorte un gain maximal des dissymétries introduites par le courant à mesurer Im et détectables sur la tension de mesure Ve. On note que cet asservissement par démodulation synchrone de la composante harmonique d'ordre 3 est peu sensible aux perturbations électromagnétiques externes, car tous les signaux de fréquence différente de la fréquence 3.f0 génèrent des produits d'intermodulation dont les composantes sont filtrées par le filtre passe-bas 34 connecté en sortie du troisième multiplieur 33. On note par ailleurs que cet asservissement n'a pas besoin d'être très rapide, car les variations provenant de paramètres extérieurs (température, vieillissement) sont relativement lentes.

Ainsi, l'enroulement de mesure 14 est utilisé à la fois pour exciter le noyau magnétique 13, pour contrôler cette excitation, pour mesurer le courant à mesurer Im, et pour compenser le flux magnétique produit dans le noyau magnétique 13 par le courant à mesurer Im (démagnétisation).

La mutualisation de ces fonctions sur un seul enroulement de mesure 14 permet de simplifier, de réduire le coût et la masse, et de faciliter la fabrication du capteur de courant à vanne de flux 10.

On note par ailleurs que la chaîne de traitement de la mesure est principalement numérique : un unique FPGA permet de mettre en oeuvre une grande partie de cette chaîne de traitement.

La numérisation de la chaîne de traitement augmente la fiabilité et la robustesse de celle-ci (notamment en température), réduit son coût, facilite sa fabrication et améliore sa reproductibilité industrielle.

L'amélioration de la régulation du point de fonctionnement grâce à la démodulation par le premier démodulateur synchrone permet par ailleurs d'obtenir une meilleure immunité aux bruits.

De plus, l'utilisation des démodulateurs synchrones permet de fonctionner à haute fréquence, ce qui autorise une bande passante importante du courant à mesurer Im tout en conservant une très bonne immunité aux perturbations électromagnétiques externes.

Comme la mesure se fait toujours dans le point de fonctionnement optimal correspondant au coude 9 de saturation, la sensibilité du capteur de courant à vanne de flux 10 est constante dans la plage de température. La précision du capteur de courant à vanne de flux 10 est donc bonne dans une plage importante de température.

Comme on l'a indiqué plus tôt, le capteur de courant à vanne de flux 10 mesure un courant à mesurer Im qui circule sur un conducteur 11.

Cette situation ne soulève pas de difficulté particulière lorsque le courant à mesurer Im est faible (inférieur à 1A par exemple).

Cependant, lorsque le courant à mesurer est important, une difficulté majeure se présente.

Le courant de démagnétisation, qui permet de compenser le flux magnétique produit dans le noyau magnétique 13 par le courant à mesurer Im, doit être lui aussi très important. La valeur du courant de démagnétisation doit être égale à celle du courant à mesurer divisé par le rapport de transformation du transformateur 12, associé aux caractéristiques de l'enroulement primaire et de l'enroulement secondaire.

Or, le nombre de spires de l'enroulement de mesure 14 est limité par son encombrement et par l'inductance résultante. Plus l'inductance est élevée, plus la vitesse de changement du courant de démagnétisation (issue du signal de démagnétisation numérique Sdm) sera limitée, et donc plus la bande passante du capteur de courant à vanne de flux 10 sera limitée. Ainsi, augmenter le nombre de spires de l'enroulement secondaire n'est pas une solution efficace.

Augmenter le courant de démagnétisation n'est pas non plus une solution efficace. En effet, cela implique de générer une tension de démagnétisation très importante sous un courant de démagnétisation important, ce qui est complexe à réaliser avec des composants standards.

On note que ce problème n'est pas propre au capteur de courant à vanne de flux 10 qui vient d'être décrit, mais concerne tout les capteurs de courant à vanne de flux (et notamment ceux qui comportent un enroulement dédié à la démagnétisation).

Pour résoudre cette difficulté, on met en oeuvre un pont diviseur de courant de manière à réduire la valeur du courant à mesurer.

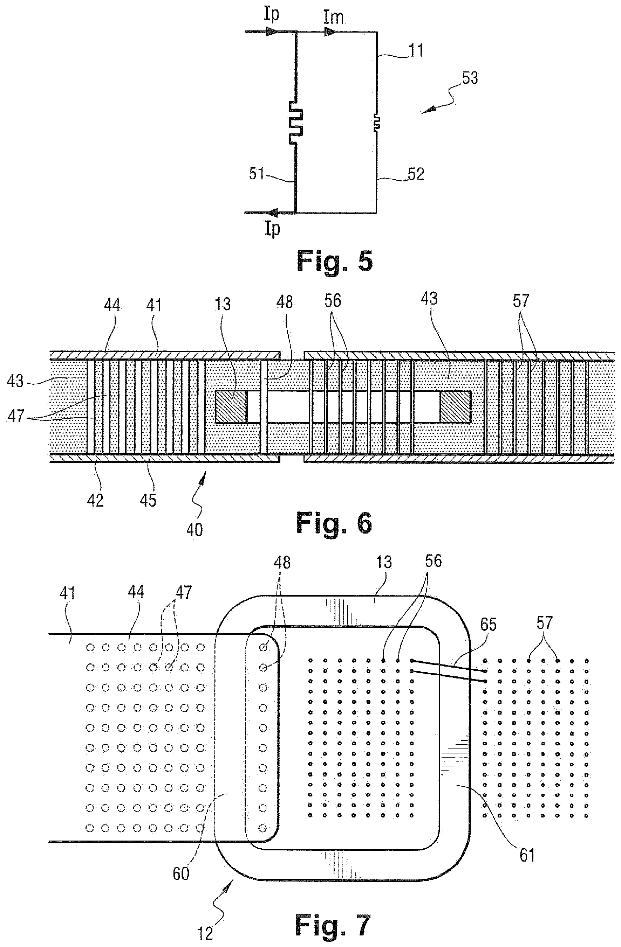

En référence aux figures 5 à 7, le capteur de courant à vanne de flux 10 comprend un circuit imprimé 40 sur lequel sont notamment montés la pluralité de composants électroniques formant la partie numérique 15 et la partie analogique 16.

Le circuit imprimé 40 comprend ici une première couche conductrice 41, une deuxième couche conductrice 42 et une couche isolante 43. La première couche conductrice 41 et la deuxième couche conductrice 42 s'étendent ici chacune sur une face opposée du circuit imprimé 40.

La première couche conductrice 41 comprend une première piste 44 et la deuxième couche conductrice 42 comprend une deuxième piste 45. La couche isolante 43 s'étend donc entre la première piste 44 et la deuxième piste 45.

Le circuit imprimé 40 comporte de plus un premier ensemble traversant d'au moins un premier trou métallisé 47 et un deuxième ensemble traversant d'au moins un deuxième trou métallisé 48. Ici, en l'occurrence, le premier ensemble traversant comprend plusieurs premiers trous métallisés 47 et le deuxième ensemble traversant comprend plusieurs deuxièmes trous métallisés 48. Les premiers trous métallisés 47 et les deuxièmes trous métallisés 48 ont ici tous un même premier diamètre.

Un « trou métallisé » pourrait aussi être appelé un « via ». Le « trou métallisé » peut être réalisé par tout type de procédé. Le « trou métallisé » peut en particulier être rendu conducteur par dépôt d'un matériau métallique ou de tout type de matériau conducteur. Le « trou métallisé » peut aussi être rendu conducteur par insertion d'un tube ou d'un rivet métallique, ou de tout type de conducteur.

Chaque premier trou métallisé 47 et chaque deuxième trou métallisé 48 relient la première piste 44 et la deuxième piste 45 en s'étendant au travers de la couche isolante 43.

Le premier ensemble traversant et le deuxième ensemble traversant forment respectivement une première branche 51 et une deuxième branche 52 d'un pont diviseur de courant 53.

Ainsi, le courant à mesurer Im est en réalité ici non pas un courant principal Ip dont on veut connaître la valeur, mais le courant à mesurer Im est issu d'une division du courant principal Ip et est utilisé pour estimer la valeur du courant principal Ip. Le courant principal Ip circule dans la première piste 44, dans la première branche 51 et la deuxième branche 52 du pont diviseur de courant 53, et dans la deuxième piste 45.

On voit bien ici que le conducteur 11 évoqué plus haut, sur lequel circule le courant à mesurer, est le deuxième ensemble traversant (ou la deuxième branche 52).

Ici, le courant principal Ip est égal à 10A.

Le nombre de premiers trous métallisés 47 du premier ensemble traversant est neuf fois plus important que celui de deuxièmes trous métallisés 48 du deuxième ensemble traversant. La deuxième résistance de la deuxième branche 52 est donc neuf fois plus élevée que la première résistance de la première branche 51.

Le courant à mesurer Im, circulant dans la deuxième branche 52 du pont diviseur de courant 53, est égal à 1A, alors que le courant circulant dans la première branche 51 du pont diviseur de courant 53 est égal à 9A.

On met ici à profit les propriétés de reproductibilité des caractéristiques électriques de plusieurs trous métallisés de même diamètre et adjacents sur le même circuit imprimé 40.

La première résistance de la première branche 51 et la deuxième résistance de la deuxième branche 52 sont mal connues mais leur rapport, lui, est connu de manière très précise grâce à cette reproductibilité.

Le premier ensemble traversant et le deuxième ensemble traversant sont donc équivalents à deux résistances *shunt* de rapport parfaitement maîtrisé.

On connaît donc de manière très précise le rapport entre le courant à mesurer Im et le courant principal Ip. Mesurer le courant à mesurer Im permet d'estimer très précisément le courant principal Ip, tout en réduisant celui-ci pour réduire le courant de démagnétisation requis.

Le courant à mesurer Im est mesuré grâce au transformateur 12 qui a été évoqué plus tôt.

Le transformateur 12 comporte le circuit imprimé 40 ou, plus exactement, une portion du circuit imprimé 40, car le circuit imprimé porte aussi la partie numérique 15 et la partie analogique 16.

Le deuxième ensemble traversant qui vient d'être décrit est aussi appelé ici « ensemble traversant primaire ». Les deuxièmes trous métallisés 48 sont des « trous métallisés primaires ».

Le circuit imprimé 40 comporte de plus un troisième ensemble traversant comportant au moins un troisième trou métallisé 56 s'étendant au travers de la couche isolante 43, et un quatrième ensemble traversant comportant au moins un quatrième trou métallisé 57 s'étendant au travers de la couche isolante 43. Ici, en l'occurrence, le troisième ensemble traversant comprend plusieurs troisièmes trous métallisés 56 et le quatrième ensemble traversant comprend plusieurs quatrièmes trous métallisés 57. Les troisièmes trous métallisés 56 et les quatrièmes trous métallisés 57 ont ici tous un même deuxième diamètre qui, pour une raison d'encombrement, est inférieur au premier diamètre des premiers trous métallisés 47 et des deuxièmes trous métallisés 48. Le nombre de troisièmes trous métallisés 56 est égal au nombre de quatrièmes trous métallisés 57.

Le troisième ensemble traversant et le quatrième ensemble traversant forment un ensemble appelé ici « ensemble traversant secondaire ». Dans l'ensemble traversant secondaire, les troisièmes trous métallisés 56 forment au moins un, en l'occurrence plusieurs « premiers trous métallisés secondaires » 56, et les quatrièmes trous métallisés 57 forment au moins un, en l'occurrence plusieurs « deuxièmes trous métallisés secondaires » 57.

Le transformateur 12 comporte de plus le noyau magnétique 13. Le noyau magnétique 13 s'étend dans une épaisseur du circuit imprimé 40.

Le noyau magnétique 13 présente la forme d'un tube de sections extérieure et intérieure rectangulaires. On note que le noyau magnétique 13 pourrait bien évidemment présenter une forme différente. Le noyau magnétique 13 comporte une portion de noyau primaire 60 et une portion de noyau secondaire 61.

L'ensemble traversant primaire s'étend à l'intérieur du noyau magnétique 13, à proximité de la portion de noyau primaire 60.

L'ensemble traversant primaire forme ainsi une portion d'un enroulement primaire du transformateur 12, ledit enroulement primaire comportant ici une seule spire.

Les premiers trous métallisés secondaires 56 s'étendent à l'intérieur du noyau magnétique 13, à proximité de la portion de noyau secondaire 61. Les deuxièmes trous métallisés secondaires 57 s'étendent à l'extérieur du noyau magnétique 13, à proximité de la portion de noyau secondaire 61.

On voit que les premiers trous métallisés secondaires 56 et les deuxièmes trous métallisés secondaires 57 sont reliés entre eux par des éléments conducteurs 65 (par exemple, mais pas nécessairement, des pistes) qui s'étendent sur la première couche conductrice 41 et sur la deuxième couche conductrice 42. Seuls deux éléments conducteurs 65 sont représentés sur la figure 7.

Le troisième ensemble traversant forme ainsi une première portion de l'enroulement secondaire du transformateur 12. Le quatrième ensemble traversant forme ainsi une deuxième portion de l'enroulement secondaire du transformateur. L'ensemble traversant secondaire forme donc une portion de l'enroulement secondaire du transformateur 12.

L'enroulement secondaire comporte une pluralité de spires, chaque spire comprenant un premier trou métallisé secondaire 56, un deuxième trou métallisé secondaire 57 et un élément conducteur 65.

Comme on l'aura compris, l'enroulement secondaire du transformateur 12 est l'enroulement de mesure 14 évoqué plus tôt.

On décrit maintenant la fabrication du circuit imprimé 40 et du noyau magnétique 13 qui s'étend dans une épaisseur du circuit imprimé 40.

Le circuit imprimé 40 comprend une première couche de « prépreg » (pour « préimprégné ») et une deuxième couche de « prépreg ». La première couche de prépreg et la deuxième couche de prépreg ne sont pas polymérisées.

Le noyau magnétique 13 comporte un mélange d'une poudre magnétique et d'une résine constituant un liant de la poudre magnétique.

La poudre magnétique est formée d'une structure cristalline, en l'occurrence de grenat d'yttrium et de fer ($Y_3Fe_{15}O_{12}$).

La résine est une résine époxy.

Le noyau magnétique 13 est déposé sur la première couche de prépreg par sérigraphie.

Puis, le noyau magnétique 13 est recouvert par la deuxième couche de prépreg.

Le circuit imprimé 40 est ensuite passé dans un four.

On perce alors le circuit imprimé 40 pour réaliser les trous métallisés qui ont été décrits.

Alternativement, il est possible fabriquer le noyau magnétique 13 en utilisant une technologie de fabrication additive par frittage laser.

La poudre magnétique est déposée sur une première couche de prépreg. Puis, un faisceau laser est utilisé pour agglomérer la couche de poudre magnétique sur des zones prédéfinies de manière à fermer le noyau magnétique 13.

Le noyau magnétique 13 est alors recouvert par la deuxième couche couche de prépreg.

La fabrication du noyau magnétique 13 par frittage laser semble plus efficace. En effet, dans le cas de la fabrication par sérigraphie, on constate que, dans le mélange de poudre magnétique et de résine, on trouve autant d'entrefers que de particules de poudre magnétique. Ces entrefers diminuent les performances du noyau magnétique 13. Dans le cas du frittage laser, les particules de la poudre magnétique sont fusionnées, ce qui évite de créer lesdits entrefers.

Bien entendu, l'invention n'est pas limitée au mode de réalisation décrit mais englobe toute variante entrant dans le champ de l'invention telle que définie par les revendications.

On a indiqué que le capteur de courant à vanne de flux comporte une partie numérique et une partie analogique, et que le convertisseur analogique numérique et le convertisseur numérique analogique appartiennent à la partie analogique. Bien sûr, on pourrait considérer que ces composants sont des composants numériques, et même qu'ils sont directement intégrés dans le FPGA (ou dans un microcontrôleur ou autre composant numérique), de sorte qu'ils appartiendraient alors à la partie numérique.

On a indiqué ici que la première couche conductrice comprenant la première piste et la deuxième couche conductrice comprenant la deuxième piste s'étendent ici chacune sur une face opposée du circuit imprimé. Bien sûr, la première couche conductrice et la deuxième couche conductrice pourraient être des couches internes du circuit imprimé, séparées par une ou plusieurs couches isolantes.

On a aussi décrit des ensembles traversant comprenant chacun un ou des trous métallisés. Les trous métallisés traversent ici une même couche isolante. Bien sûr, les trous métallisés pourraient traverser plusieurs couches isolantes, voir même une ou des couches isolantes et une ou des couches conductrices. Des ensembles traversant distincts pourraient aussi traverser des piles de couches distinctes.

On a indiqué ici que l'ensemble traversant secondaire comprend au moins un premier trou métallisé secondaire et au moins un deuxième trou métallisé secondaire qui s'étendent de part et d'autre d'une portion de noyau secondaire du noyau magnétique. Bien sûr, il est possible aussi que l'ensemble traversant primaire comprenne au moins un premier trou métallisé primaire et au moins un deuxième trou métallisé primaire qui s'étendent de part et d'autre d'une portion de noyau primaire du noyau magnétique. Les deux configurations peuvent aussi coexister.

## Revendications

1. Capteur de courant à vanne de flux comportant un noyau magnétique (13) qui s'étend autour d'un conducteur (11) sur lequel circule un courant à mesurer (Im), un enroulement de mesure (14), un circuit d'excitation (23) agencé pour générer un signal d'excitation numérique (Se), un circuit d'acquisition (17) comprenant un convertisseur analogique numérique (20) et agencé pour acquérir une tension de mesure analogique (Ve) aux bornes de l'enroulement de mesure (14) et pour produire un signal de mesure numérique (Sm), un circuit d'asservissement de démagnétisation (32) agencé pour produire, à partir du signal de mesure numérique, un signal de démagnétisation numérique (Sdm) destiné à compenser un flux magnétique produit par le courant à mesurer, un sommateur (36) agencé pour sommer le signal d'excitation numérique et le signal de démagnétisation numérique de manière à obtenir un signal d'injection numérique (Si), et un circuit d'injection (37) comprenant un convertisseur numérique analogique (38) et agencé pour produire un courant d'excitation analogique à partir du signal d'injection numérique et pour injecter le courant d'excitation analogique dans l'enroulement de mesure.

2. Capteur de courant à vanne de flux selon la revendication 1, dans lequel le signal d'excitation numérique est obtenu à partir d'un signal de référence numérique de fréquence f0 et d'un signal de référence numérique de fréquence 3.f0.

3. Capteur de courant à vanne de flux selon la revendication 2, dans lequel le circuit d'excitation comporte un circuit d'asservissement d'excitation (25) qui est agencé pour asservir le signal d'excitation numérique de manière à annuler une composante de fréquence 3.f0 de la tension de mesure analogique.

4. Capteur de courant à vanne de flux selon la revendication 3, dans lequel le circuit d'asservissement d'excitation comporte un premier multiplieur (27) agencé pour multiplier le signal de mesure numérique par un signal de démodulation numérique de fréquence 3.f0.

5. Capteur de courant à vanne de flux selon la revendication 4, dans lequel le circuit d'asservissement d'excitation comporte en outre un intégrateur (29), un premier amplificateur (30) connecté à une sortie de l'intégrateur et agencé pour produire un signal d'erreur numérique, et un deuxième multiplieur (28) qui multiplie un signal d'excitation numérique brut (Seb) par le signal d'erreur numérique pour obtenir le signal d'excitation numérique.

6. Capteur de courant à vanne de flux selon la revendication 1, dans lequel le circuit d'asservissement de démagnétisation comporte un troisième multiplieur (33) agencé pour multiplier le signal de mesure numérique par un signal de démodulation numérique de fréquence 2.f0.

7. Capteur de courant à vanne de flux selon la revendication 6, dans lequel le circuit d'asservissement de démagnétisation comporte en outre un filtre passe-bas (34), un deuxième amplificateur (35) connecté à une sortie du filtre passe-bas et agencé pour produire le signal de démagnétisation numérique.

## Patentansprüche

1. Fluxgate-Stromsensor, umfassend einen Magnetkern (13), der sich um einen Leiter (11) erstreckt, auf dem ein zu messender Strom (Im) fließt, eine Messwicklung (14), eine Erregerschaltung (23), die ausgebildet ist, ein digitales Erregersignal (Se) zu erzeugen, eine Erfassungsschaltung (17), die einen Analog-Digital-Wandler (20) umfasst und ausgebildet ist, eine analoge Messspannung (Ve) an den Anschlussklemmen der Messwicklung (14) zu erfassen und ein digitales Messsignal (Sm) zu erzeugen, eine Entmagnetisierungsregelschaltung (32), die ausgebildet ist, anhand des digitalen Messsignals ein digitales Entmagnetisierungssignal (Sdm) zu erzeugen, das dazu bestimmt ist, einen von dem zu messenden Strom erzeugten Magnetfluss zu kompensieren, einen Summierer (36), der ausgebildet ist, das digitale Erregersignal und das digitale Entmagnetisierungssignal zu summieren, um ein digitales Injektionssignal (Si) zu erhalten, und eine Injektionsschaltung (37), die einen Digital-Analog-Wandler (38) umfasst und ausgebildet ist, einen analogen Erregerstrom anhand des digitalen Injektionssignals zu erzeugen und den analogen Erregerstrom in die Messwicklung zu injizieren.

2. Fluxgate-Stromsensor nach Anspruch 1, bei dem das digitale Erregersignal anhand eines digitalen Referenzsignals mit Frequenz f0 und eines digitalen Referenzsignals mit Frequenz 3.f0 erhalten wird.

3. Fluxgate-Stromsensor nach Anspruch 2, bei dem die Erregerschaltung eine Erregerregelschaltung (25) umfasst, die ausgebildet ist, das digitale Erregersignal zu regeln, um eine Frequenzkomponente 3.f0 der analogen Messspannung zu annullieren.

4. Fluxgate-Stromsensor nach Anspruch 3, bei dem die Erregerregelschaltung einen ersten Multiplizierer (27) umfasst, der ausgebildet ist, das digitale Messsignal mit einem digitalen Demodulationssignal mit Frequenz 3.f0 zu multiplizieren.

5. Fluxgate-Stromsensor nach Anspruch 4, bei dem die Erregerregelschaltung ferner einen Integrator (29), einen ersten Verstärker (30), der mit einem Ausgang des Integrators verbunden und ausgebildet ist, ein digitales Fehlersignal zu erzeugen, und einen zweiten Multiplizierer (28) umfasst, der ein rohes digitales Erregersignal (Seb) mit dem digitalen Fehlersignal multipliziert, um das digitale Erregersignal zu erhalten.

6. Fluxgate-Stromsensor nach Anspruch 1, bei dem die Entmagnetisierungsregelschaltung einen dritten Multiplizierer (33) umfasst, der ausgebildet ist, das digitale Messignal mit einem digitalen Demodulationssignal mit Frequenz 2.f0 zu multiplizieren.

7. Fluxgate-Stromsensor nach Anspruch 6, bei dem die Entmagnetisierungsregelschaltung ferner ein Tiefpassfilter (34), einen zweiten Verstärker (35) umfasst, der mit einem Ausgang des Tiefpassfilters verbunden und ausgebildet ist, das digitale Entmagnetisierungssignal zu erzeugen.

**Claims**

1. A flux gate current sensor comprising a magnetic core (13) that extends around a conductor (11) in which there flows a current that is to be measured (Im), a measurement winding (14), an excitation circuit (23) arranged to generate a digital excitation signal (Se), an acquisition circuit (17) comprising an analog-to-digital converter (20) and arranged to acquire an analog measurement voltage (Ve) from the terminals of the measurement winding (14) and to produce a digital measurement signal (Sm), a demagnetization servocontrol circuit (32) arranged to use the digital measurement signal to produce a digital demagnetization signal (Sdm) for compensating magnetic flux produced by the current that is to be measured, a summing circuit (36) arranged to sum the digital excitation signal and the digital demagnetization signal so as to obtain a digital injection signal (Si), and an injection circuit (37) comprising a digital-to-analog converter (38) and arranged to produce an analog excitation current from the digital injection signal and to inject the analog excitation current into the measurement winding.

2. A flux gate current sensor according to claim 1, wherein the digital excitation signal is obtained from a digital reference signal of frequency f0 and from a digital reference signal of frequency 3.f0.

3. A flux gate current sensor according to claim 2, wherein the excitation circuit includes an excitation servocontrol circuit (25) that is arranged to servocontrol the digital excitation signal in such a manner as to zero a component of frequency 3.f0 of the analog measurement voltage.

4. A flux gate current sensor according to claim 3, wherein the excitation servocontrol circuit includes a first multiplier (27) arranged to multiply the digital measurement signal by a digital demodulation signal of frequency 3.f0.

5. A flux gate current sensor according to claim 4, wherein the excitation servocontrol circuit further includes an integrator (29), a first amplifier (30) connected to an output of the integrator and arranged to produce a digital error signal, and a second multiplier (28) that multiplies a raw digital excitation signal (Seb) by the digital error signal in order to obtain the digital excitation signal.

6. A flux gate current sensor according to claim 1, wherein the demagnetization servocontrol circuit includes a third multiplier (33) arranged to multiply the digital measurement signal by a digital demodulation signal of frequency 2.f0.

7. A flux gate current sensor according to claim 6, wherein the demagnetization servocontrol circuit further includes a lowpass filter (34), and a second amplifier (35) connected to an output of the lowpass filter and arranged to produce the digital demagnetization signal.

B (T)

ΔB

9

H (At/m)

ΔH

**Fig. 1**

1

2

5

3

4

Asservissement
d'amplitude du courant

6

$I_m$

8

Courant de
démagnétisation

Asservissement
de la démagnétisation

**Fig. 2**

$V_{ex}$

$I_{ex}$

**Fig. 3**

Fig. 4

**Fig. 5**

**Fig. 6**

**Fig. 7**